# EUROPEAN PATENT APPLICATION

(11) **EP 3 312 821 A1**
(43) Date of publication of application: **25.04.2018**
(21) Application number: 16812010.3
(22) Date of filing: 16.06.2016
(51) Int. Cl.: G08G 1/08, G08G 1/095, H05K 1/02, G09F 13/22, G08G 1/087, H05B 37/02, F21S 8/00

(54) **INTELLIGENT TRAFFIC CONTROL DEVICE AND SYSTEM**

(30) Priority: 17.06.2015 MX 2015007836
(71) Applicant: Media Trade Software, S.A. De C.V., Ciudad de México 04970 (MX)
(72) Inventor: ENRIQUEZ, Sergio Rafael, Ciudad de México 04970 (MX)
(74) Representative: Ponti & Partners, S.L.P
(86) International application number: PCT/MX2016/000062
(87) International publication number: WO 2016/204599

(57) **Abstract**

An intelligent traffic control apparatus and system is disclosed. The intelligent traffic control apparatus and system of the present invention is based on a traffic light which makes decisions on the time of red and green lights based on the information that comes from the vehicles and which gives a very significant saving as it does away with the manufacturing of seconds counters. As implemented, the intelligent traffic control apparatus and system allow that both the travel times and the fuel consumption are reduced as well as the polluting emissions.

## Description

### FIELD OF THE INVENTION

The present invention is generally related to intelligent transit systems.

### BACKGROUND OF THE INVENTION

The advances in mobile IT and wireless communications may offer increasing possibilities for the development of intelligent traffic control systems. These systems involve a wide degree of technologies based on telecommunications and electronics and their incorporation in vehicle infrastructure and transport systems. The main aim of intelligent traffic control systems is to reduce traffic jams and the improvement of traffic safety. In several parts of the world, intelligent traffic control systems can be found which include a traditional traffic light and a seconds counter, but these systems have many disadvantages and limitations.

With the aim of overcoming said disadvantages and limitations in addition to enabling different uses and properties superior to the existing traffic control systems, the development of a new intelligent traffic control apparatus and system was devised based on a traffic light which makes decisions on the time of red and green lights based on the information that comes from the vehicles and gives a very significant saving as it does away with the manufacturing of seconds counters.

### BRIEF DESCRIPTION OF THE INVENTION

The characteristic details of this novel intelligent traffic control apparatus and system are clearly shown in the following description and in the accompanying drawings.

A first object of the present invention is to provide a light emitting diode (LEDS) lamp apparatus with timer and automatic time display capacity. The light emitting diode lamp apparatus may be of both a red light board and a green light board comprising 48 independent circuits of LEDS of 3 diodes in series, powered with 8 volts, and a central circuit of 30 series of 5 LEDS powered with 12 volts for a total of 294 LEDS per lamp. The green colour lamps consume 30 watts and the red colour lamps consume 42 watts. The green and red light boards are welded on a circular board designed with 2mm tracks. The control board consists of 1 PIC circuit with 6 shift registers which communicate with one another to change the state of the traffic light, they have an internal clock which may be configured to have a period of 48 and 24 seconds, respectively, for the red and green light lamps but they may also be adjusted for different time periods according to the position and the speed of the vehicles in the streets. The red and green light lamps and the circuit are connected by headers and marker cables on the side of the anode.

A second object of the present invention is to provide an intelligent traffic control system comprising the timer and automatic time display apparatus connected with sensors which can be located in street intersections and which act as measuring devices of the time of duration of each traffic light and of its variation.

A third object of the present invention is to provide an intelligent traffic control system which is remotely connected with all the traffic lights for synchronization of green light waves to speed up the mobility of cars, trucks and emergency transport such as ambulances and fire engines.

A fourth object of the present invention is to provide an intelligent traffic control system comprising detection alarms due to lack of power when there is a power outage in one or more traffic lights and, optionally, a solar screen in each traffic light so that a battery is charged with power in those cases where there has been a power outage of the traffic light.

### DETAILED DESCRIPTION OF THE DRAWINGS

The details with the illustrations are included below to aid the examiners to more closely understand and more broadly explain this invention:
Figure 1 illustrates a timer and time display apparatus of the present invention in a red light modality.
Figure 2 illustrates a timer and time display apparatus of the present invention in a red light modality in addition to being installed in a traffic light casing in addition to a timer and time display apparatus of the present invention in a green light modality.
Figure 3 illustrates a specific modality of the timer and time display apparatus of the present invention with some of its structural components organized in a particular manner.
Figure 4 illustrates a specific modality of the timer and time display apparatus of the present invention with some of its structural components organized in a particular manner.
Figure 5 illustrates a specific modality of the timer and time display apparatus of the present invention with some of its structural components organized in a particular manner.
Figure 6 illustrates the design of a particular circuit in a specific modality of the timer and time display apparatus of the present invention.

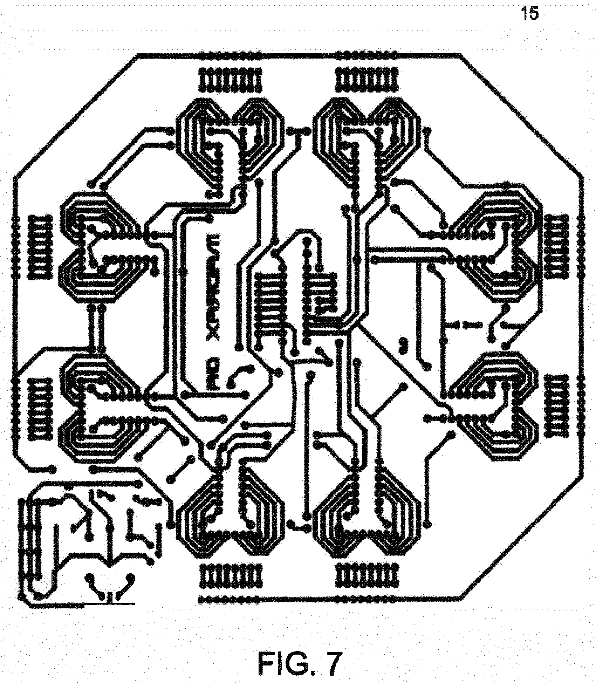

Figure 7 illustrates the design of a particular circuit in another specific modality of the timer and time display apparatus of the present invention.
Figure 8 illustrates a specific modality of implementation of the intelligent traffic control system of the present application.
Figure 9 illustrates another specific modality of implementation of the intelligent traffic control system of the present application.
Figure 10 additionally illustrates another specific modality of implementation of the intelligent traffic control system of the present application.

### DETAILED DESCRIPTION OF THE INVENTION

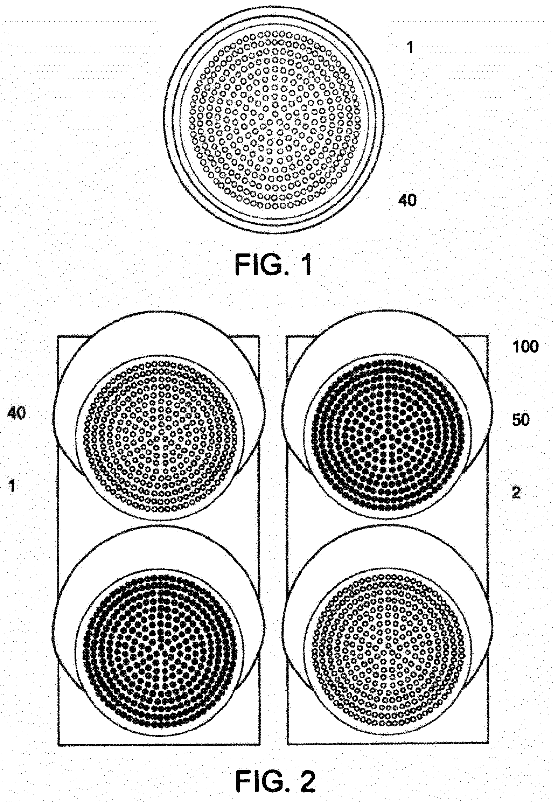

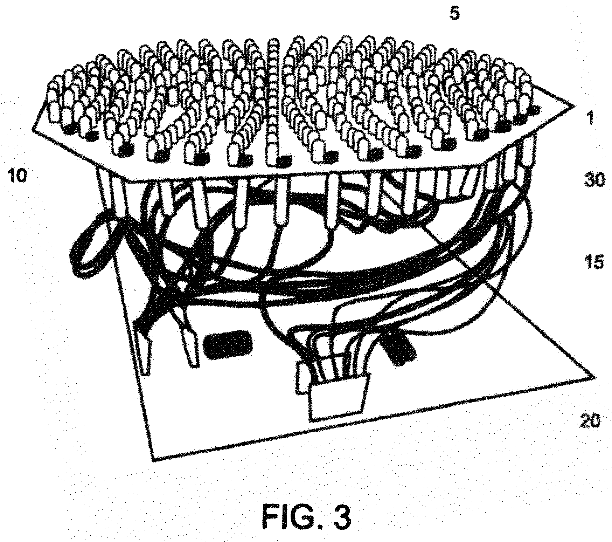

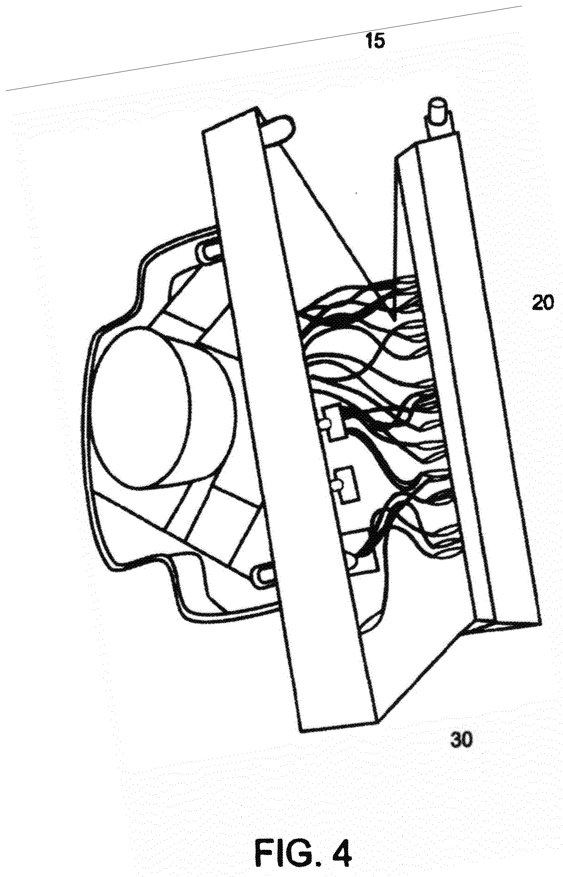

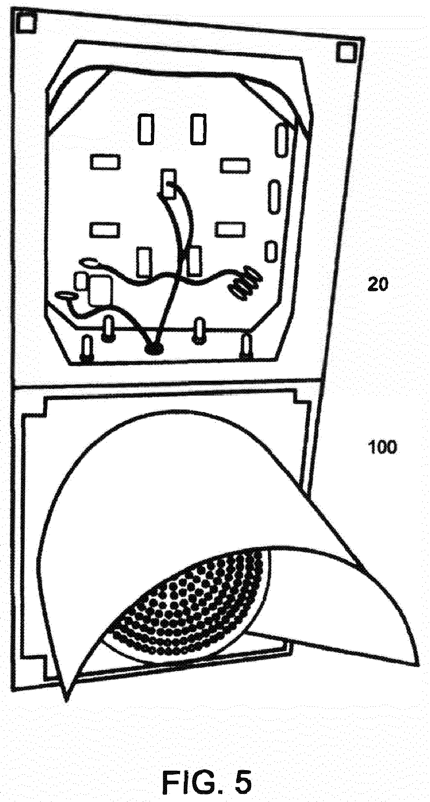

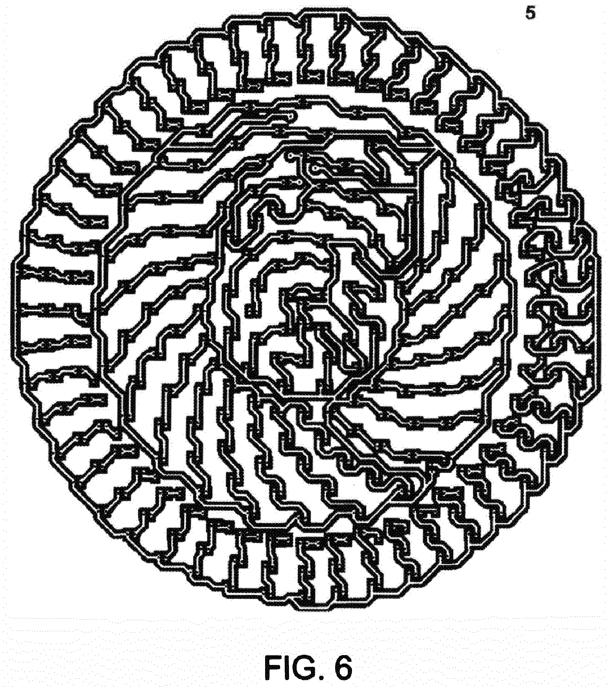

According to a first aspect of the invention, a light emitting diode (LEDS) lamp apparatus 1, 2 is disclosed with timer and automatic time display capacity. As can be observed in Figures 1 to 6, the LED apparatus 1, 2 may be of both a red light 40 and a green light 50 comprising a particular design of 48 independent circuits of LEDS of 3 diodes in series 5, powered with 8 volts, and a central circuit 15 of 30 series of 5 LEDS powered with 12 volts for a total of 294 LEDS per lamp. The green light lamps 40 consume 30 watts and the red light lamps consume 42 watts. Some green light and red light lamps are welded on a circular board 10 with 2mm tracks. A control board 20 consists of 1 PIC circuit with 6 shift registers which communicate with one another to change the state of the traffic light and has an internal clock which may be configured to have a time period of 48 and 24 seconds, respectively, for the red and green light lamps 40, 50 but it may also be adjusted for different time periods according to the position and the speed of the vehicles in the streets. The red and green light lamps 40, 50 and the central circuit 15 are connected by headers and marker cables 30 on the side of the anode. The great advantage of the intelligent traffic control apparatus based on the structural characteristics described above is that the apparatus makes decisions on the time of red and green lights based on the information that comes from the vehicles and gives a very significant saving as it does away with the manufacturing of seconds counters. The information obtained from the intelligent traffic control apparatuses can be captured, for example, from mobile telephone devices used by the vehicle drivers or directly from the vehicles themselves. The manner of capturing of the information obtained about the traffic lights may be made, for example, through an application installed in a mobile phone of a driver which sends signals and information about the position and speed of the driver's vehicle. Another manner of capturing the information obtained from the traffic control apparatuses may also be directly from the electronic or communication system of the vehicle which, embedded therein, has the capacity of sending information on its position and speed to the traffic control apparatuses.

The LED lamps 40, 50 of the apparatus 1 of the present invention may also replace the lights of any already installed traffic light since it is not necessary to change a casing 100 of existing traffic lights thus providing an economical form for a city to adopt the intelligent traffic control apparatus 1 of the present application.

In one modality of the apparatus, the apparatus 1 is supplied with information about the position and speed of all the vehicles on the streets. Once the apparatus is configured to deal with a particular transit situation, this information is used to calculate how to organize the changes in colour of the red and green colour lights 40, 50 with the aim of speeding up the traffic. As implemented, the apparatus 1 allows that both the travel times and the fuel consumption are reduced as well as the polluting emissions. The apparatus 1 supplied with the aforementioned information also enables supplying or processing information to the vehicle drivers with respect to the recommendable speeds in accordance with the red and green colour lights 40, 50 of the traffic lights and the amount of vehicles in traffic jams, and this information may also be transferred to an intelligent traffic control system to improve traffic regulation by means of the traffic lights.

The apparatus 1 may decrease CO₂ emissions by 6.5% on average and the time that the vehicle drivers spend waiting in the city crossroads in hours of maximum traffic flow is reduced by 28% on average. Another advantage of the apparatus 1 of the present application is that when the vehicle driver has the possibility of knowing how much time is left until a traffic light changes, it is possible to save the vehicle's clutch and brake. Finally, the apparatus 1 of the present invention enables that, in the human question, less stress is generated as it is not necessary to sound the horn thinking that the traffic light is not working.

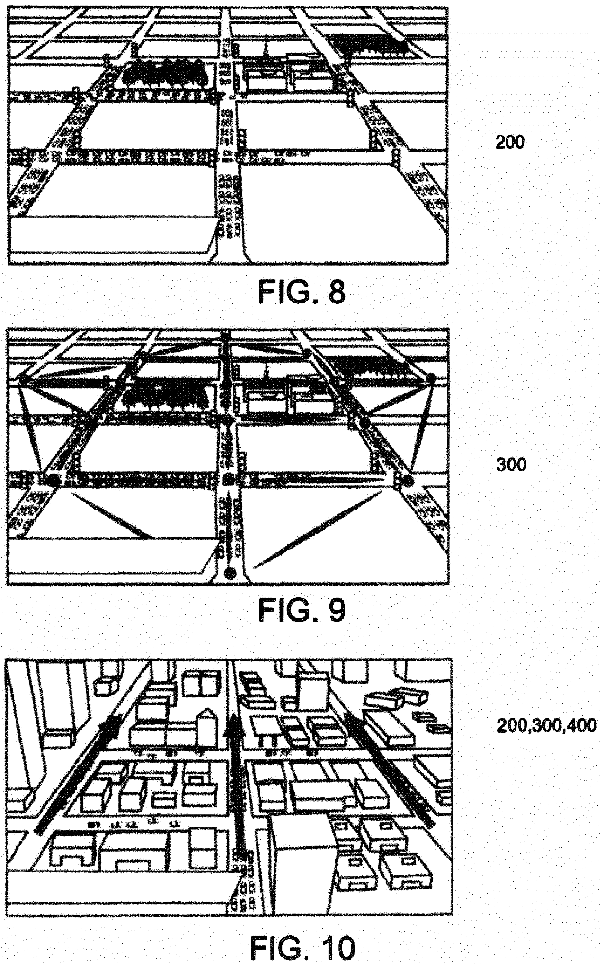

According to a second aspect of the invention, an intelligent traffic control system 200 is disclosed comprising a timer and automatic time display apparatus connected with sensors that can be located in street intersections and which act as measuring devices of the time of duration of each traffic light and of its variation. The configuration of the intelligent traffic control system above is illustrated in Figures 8 to 10.

According to a third aspect of the invention, an intelligent traffic control system 300 is disclosed which is remotely connected with all the traffic lights for synchronization of green light waves to speed up the mobility of cars, trucks and emergency transport, such as ambulances and fire engines. The configuration of the intelligent traffic control system above is illustrated in Figures 8 to 10.

According to a fourth aspect of the invention, an intelligent traffic control system 400 is disclosed which monitors in real time and further comprising detection alarms due to lack of power when there is a power outage in one or more traffic lights. The traffic control system further optionally comprises a solar screen in each traffic light so that a battery is charged with power in those cases where there has been a power outage of the traffic light.

The traffic control system 200, 300, 400 controls the traffic lights from a computing centre which administers the normal operation of the system and which can adapt to existing computing centres and is easily programmable for respective needs of the traffic control of a city.

The traffic control system 200, 300, 400 can be used to prioritize the transit of fire engines or ambulances or any type of emergency vehicle service transiting through the streets of a city. In one modality of the prioritization mode of emergency services, a continuous green wave is generated with at least 5 traffic lights in advance so that, with that advantage time, it enables car drivers to be able to move their vehicles to allow free passage. In another modality of the prioritization mode of emergency services, the green wave for car drivers is of 15 to 30 blocks saving an approximate time of 30% in reaching their destination.

Both the intelligent traffic control apparatus and system are adaptable to any traffic control system.

## Claims

1. A timer and automatic time display apparatus, comprising:
a plurality of light emitting diode lamps (LEDs), the plurality of LED lamps that are particularly designed in independent circuits and in series, the LED lamps that are of red light or green light, the LED lamps that are coupled to a board;
a central circuit of LEDs in series coupled to the plurality of LED lamps, wherein the plurality of LED lamps and the central circuit are connected by one or more headers and marker cables on the side of the anode; and
a control board comprising one or more PIC circuits with one or more shift registers which communicate with one another to change the state of the apparatus from green light to red light or vice-versa, the control board further comprising one or more internal clocks which can be configured and adjusted for a particular period of time according to speed information and/or position information of vehicles in the streets.

2. The apparatus according to claim 1, wherein the board wherethrough the LED lamps are coupled is circular.

3. The apparatus according to claim 1, further comprising a casing.

4. The apparatus according to claim 1, wherein changes of colour from red light to green light and vice-versa are calculated based on the information about the speed and/or position of vehicles in the streets.

5. The apparatus according to claim 1, wherein the apparatus allows that a travel time, a fuel consumption and/or polluting emissions are reduced.

6. The apparatus according to claim 1, wherein the speed information and/or position information of the vehicles can feedback to the vehicles with the aim of recommending particular speeds to vehicle drivers in accordance with the lights of the traffic lights and/or the amount of cars in traffic jams.

7. The apparatus according to claim 1, wherein the information is captured through a mobile phone infrastructure, whether from mobile telephone devices of vehicle drivers or directly from the vehicles themselves.

8. The apparatus according to claim 7, wherein information is captured through an application installed in a mobile telephone device of a vehicle driver which sends signals and information about the position and speed of the driver's vehicle.

9. The apparatus according to claim 7, wherein the information is captured from an electronic or communication system of the vehicle which, embedded therein, has the capacity of sending information about its position and speed to the apparatus.

10. The apparatus according to claim 1, wherein the plurality of LED lamps comprises 48 independent circuits of LEDs of 3 diodes in series powered with 8 volts.

11. The apparatus according to claim 1, wherein the central circuit comprises 30 series of 5 LEDs powered with 12 volts.

12. An intelligent traffic control system, comprising:
the timer and automatic time display apparatus according to any of claims 1 to 11; and
one or more sensors which are located in street intersections and which act as measuring devices of the time of duration of a traffic light and of its variation.

13. The intelligent traffic control system according to claim 12, further comprising one or more remotely-connected traffic lights for synchronization of green light waves to speed up the mobility of cars, trucks and emergency transport, such as ambulance or fire engines.

14. The intelligent traffic control system according to claim 12, comprising a computing centre which administers the normal operation of the system and which can adapt to existing computing centres as it is easily configured for respective needs of the traffic control of a city.

15. The intelligent traffic control system according to claim 12, further comprising one or more detection alarms due to lack of power when there is a light outage in one or more traffic lights.

16. The intelligent traffic control system according to claim 15, further comprising one or more solar screens in each traffic light so that a battery is charged with energy in those cases where there has been a power outage of the traffic light.

17. The intelligent traffic control system according to claim 13, wherein, in a prioritization mode of emergency services, a continuous green wave is generated with at least 5 traffic lights in advance so that, with that advantage time, it enables car drivers to be able to move their vehicles to allow the free passage of emergency transport vehicles.

18. The intelligent traffic control system according to claim 17, wherein the green wave for car drivers is of 15 to 30 blocks.
